(19) Europäisches Patentamt
European Patent Office
Office européen des brevets

(11) **EP 2 985 610 A1**

(12) **EUROPEAN PATENT APPLICATION**

(43) Date of publication:
**17.02.2016 Bulletin 2016/07**

(21) Application number: **15177715.8**

(22) Date of filing: **21.07.2015**

(51) Int Cl.:
**G01R 13/02** *(2006.01)*     **G01R 13/34** *(2006.01)*
**G01R 31/317** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **21.07.2014 US 201462026943 P**
**29.04.2015 US 201514699306**

(71) Applicant: **Tektronix, Inc.**
**Beaverton, Oregon 97077-0001 (US)**

(72) Inventor: **Guenther, Mark**
**Portland, OR 97229 (US)**

(74) Representative: **Clarke, Jeffrey David**
**HGF Limited**
**Fountain Precinct**
**Balm Green**
**Sheffield S1 2JA (GB)**

(54) **METHOD FOR DETERMINING A CORRELATED WAVEFORM ON A REAL TIME OSCILLOSCOPE**

(57)     A method for determining a correlated waveform, including acquiring a generalized waveform record with a repeating pattern, determining a possibly corrected recovered clock signal for the generalized waveform record, selecting a new sample rate that is higher than the clock rate by N time, where N is an integer greater than 1, resampling the generalized waveform so that the new samples fall precisely on two clocks instants of the recovered clock signal that define each unit interval, and on N-1 additional instants equally spaced between the two clock instants of each unit interval to create a resampled waveform, and forming the correlated waveform by taking the mean values of all samples from the resampled waveform having the same offset into a pattern repeat in unit intervals or fractions thereof

FIG. 1

EP 2 985 610 A1

**Description**

TECHNICAL FIELD

This disclosure relates to generating the correlated waveform corresponding to a repeating data pattern in a generalized waveform with improved accuracy in the presence of large deterministic jitter.

BACKGROUND

In the field of high-speed serial data communication, waveform fidelity and system timing and voltage margin have historically been assessed using an eye diagram.

In many cases, it is practical to evaluate components or systems using waveforms that carry a cyclically repeating data pattern. A generalized waveform invariably exhibits both correlated and uncorrelated impairments. Both for eye diagram production and noise/jitter analysis, it is sometimes necessary to separate the correlated waveform from the uncorrelated jitter and noise. A correlated waveform is defined as a conceptual waveform representing one full pattern-cycle of the generalized waveform consisting of many such pattern-cycles, and exemplifying the deterministic amplitude and phase characteristics correlated with the repeating pattern.

Typically, a correlated waveform is obtained by triggering a signal acquisition device using a stable trigger, as derived from a clock-recovery circuit and synchronized with a repeating pattern, and by averaging together many samples corresponding to each delay-time relative to the trigger point so that effects not correlated with the repeating waveform are averaged out over time. However, in the presence of large periodic jitter, the eye diagram generated based on the averaged correlated waveform may misrepresent the shape of the eye opening.

Embodiments of the disclosed technology address these and other limitations in the prior art.

SUMMARY

Embodiments of the disclosed technology include a method for determining a correlated waveform, including acquiring a generalized waveform record with a repeating pattern by an acquisition unit of a test and measurement instrument; determining a recovered clock signal for the generalized waveform record; selecting a new sample rate that is higher than the clock rate by a factor ofN, where N is an integer greater than 1; resampling the generalized waveform so that the new samples fall precisely on two clocks instants of the recovered clock signal that define each unit interval, and on N-1 additional instants equally spaced between the two clock instants of each unit interval to create a resampled waveform; truncating the resampled waveform to L number of pattern repeats, where L is an integer; calculating a mean value across all L observations for each of the N*K pattern samples, where K is the number of bits in the repeating pattern; and concatenating the N*K mean values to form the correlated waveform on a new time axis normalized to the recovered clock rate.

Embodiments of the disclosed technology also include a test and measurement instrument, comprising acquisition means configured to receive a generalized waveform record with a repeating pattern; and a processor. The processor is configured to determine a recovered clock signal for the generalized waveform record; select a new sample rate that is higher than the clock rate by a factor ofN, where N is an integer greater than 1; resample the generalized waveform so that the new samples fall precisely on two clocks instants of the recovered clock signal that define each unit interval, and on N-1 additional instants equally spaced between the two clock instants of each unit interval to create a resampled waveform; truncate the resampled waveform to L number of pattern repeats, where L is an integer; calculate a mean value across all L observations for each of the N*K pattern samples, where K is the number of bits in the repeating pattern; and concatenate the N*K mean values to form the correlated waveform on a new time axis normalized to the recovered clock rate.

BRIEF DESCRIPTION OF THE DRAWINGS

Figure 1 is a block diagram of a test and measurement instrument for implementing the method of the disclosed technology.
Figure 2 shows five overlaid repeats of a repeating pattern of serial data bits that include uncorrelated jitter and noise.
Figure 3 shows a correlated waveform based on the repeating pattern in Figure 2.
Figure 4 shows one instant of a repeating waveform with two bits.
Figure 5 shows 20 overlaid pattern repeats of a waveform with a high-amplitude deterministic phase modulation.
Figure 6 shows the set of waveform segments in Figure 5 with an overlaid correlated waveform determined based on the set of waveforms.

Figure 7 shows a correlated eye diagram formed using the correlated waveform of Figure 6 with a preferred correlated eye diagram.

Figure 8 shows an eye diagram after a correlated waveform of Figure 6 has been convolved with non-correlated effects.

Figure 9 shows an eye diagram generated according to the disclosed technology.

Figure 10 is a flow chart illustrating embodiments of the disclosed technology.

Figure 11 shows two unit intervals of a waveform with the original waveform samples spaced evenly in time and resampled at a factor ofN times the recovered clock.

Figure 12 is a flow chart illustrating other embodiments of the disclosed technology.

Figure 13 is a time interval error versus time plot, where the error has a random and a large-amplitude deterministic component

Figure 14 is plot showing a time interval error corresponding to a specific component of deterministic jitter.

Figure 15 is a plot showing a time interval error derived from corrected clock recovery times.

DETAILED DESCRIPTION

In the drawings, which are not necessarily to scale, like or corresponding elements of the disclosed systems and methods are denoted by the same reference numerals.

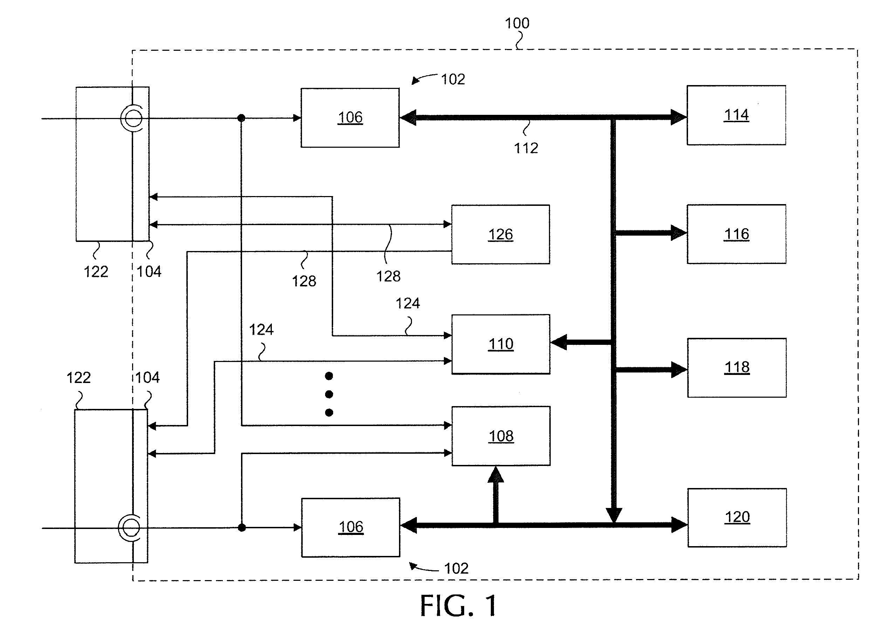

Referring now to Figure 1, there is shown a representative block diagram of a real-time oscilloscope according to some embodiment of the present invention for implementing the disclosed technology. Although a real-time oscilloscope is shown and discussed below, any type of test and measurement instrument capable of acquiring a suitable representation of a time-domain waveform may be used.

The oscilloscope 100 may have separate signal channels 102 coupled to accessory interfaces 104, two of which are represented in Figure 1. Each signal channel 102 may have a separate acquisition unit 106 that may include, for example, known electronic circuitry and/or devices for at least receiving an analog waveform input signal from the a device under test or channel, such as probes 122, and converting the received signal into digitized samples. Each of the analog waveform input signals coupled to the signal channels 102 may also be coupled to trigger circuitry 108. The acquisition unit 106 and the trigger circuitry 108 may be coupled to a programmable processing means 110 via a system bus 112. The system bus 112 may be further coupled to memory means 114 that may, for example, take the form of RAM, ROM and/or cache memory. RAM memory is operable to store volatile data, such as the digitized samples of the analog waveform input signal generated by the acquisition unit 106. The system bus 112 may be further coupled to display circuitry 116 for controlling a display section (not shown), a mass storage unit or units 118, such as a hard disk drive, CD ROM drive, tape drive, floppy drive or the like that reads from and/or writes to appropriate mass storage media, and the front panel controls 120. It should be understood that any number of signal channels 102 may be included in the oscilloscope 100 with each channel having separate acquisitions means 106.

Executable instructions for implementing the methods according to embodiments of the disclosed technology and for otherwise controlling the oscilloscope 100 may be stored and accessed from memory means 114, more particularly, for example, from ROM. Alternatively, the executable instructions may be stored and accessed from mass storage media of the mass storage unit 118 which in some embodiments may be included within memory means 114. The processing means 110 may be implemented as, for example, one or more programmable microprocessors. The processing means 110 may also be implemented using multiple programmable controllers and/or one or more programmable digital signal processors. In yet another embodiment, when the processing means 110 is implemented using multiple controllers one may be used to control the acquisition and processing of the analog waveform input signal while the second may control the other operations of the oscilloscope 100. The oscilloscope 100 may be controlled using an operating system that is stored and accessed within one or more processors or controllers 110 and associated memory means 114.

The display circuitry 116 may include a display controller (not shown) for receiving instructions for controlling the display section from processing means 110 and may receive data as well from a digital signal processor, for example, that is a part of processing means 110 for display by the display section. A bus controller (not shown) may also be included within the processing means 110 or included separately within the oscilloscope 100 for monitoring interfaces 104 and probes 122. The bus controller may also control communications between the probes 122 and the processing means 110 via communications bus 124. The bus 124 may comprise an $I^2C$ bus, IEEE 1494 bus, USB bus or the like, that provides bi-directional communications.

A power supply 126 may receive control signals from the processing means 110 for controlling the electrical power to the probes 122 via voltage lines 128 and the accessory interfaces 104.

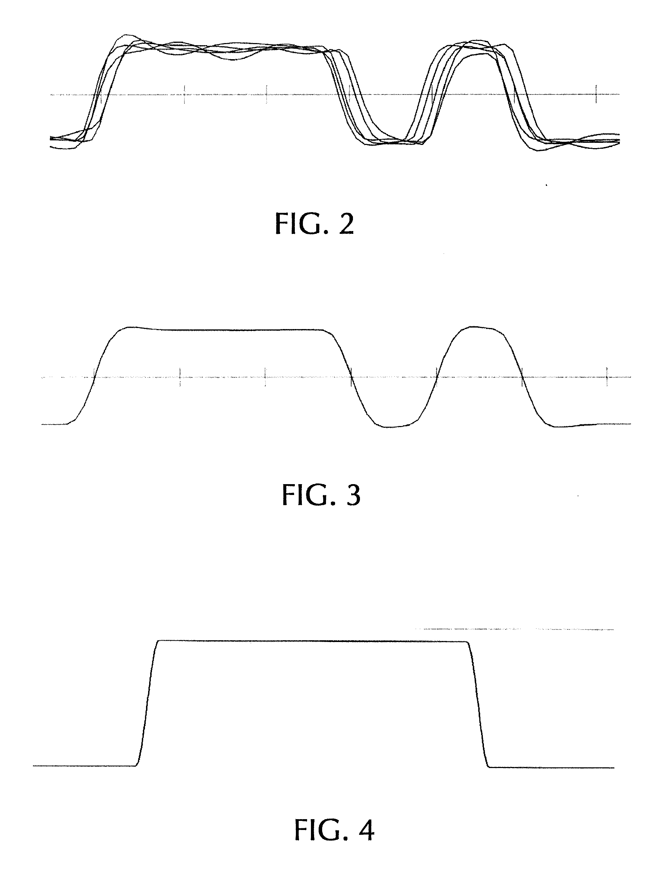

Figure 2 shows an example of five overlaid repeats of a noisy repeating pattern of serial data bits that have been received by the acquisition units 106 of the oscilloscope 100. The seven-bit repeating pattern is discernable, but it is also clear that jitter and noise cause each individual waveform to vary. Many observations of the waveform in Figure 2 are averaged together along any vertical line to obtain the waveform in Figure 3.

The waveform in Figure 3 may be acquired using a sampling oscilloscope, and a reasonable likeness obtained on a real-time digital oscilloscope by setting the acquisition mode to "average." On a real-time oscilloscope, however, even though all of the overlaid waveforms in Figure 2 share the same sample rate, aligning them precisely according to the clock-recovery-derived pattern trigger may demand that they be overlaid with different timing skews that cause the samples from one waveform to not align timewise with samples from another waveform.

Further, the clock recovery process is often dynamically variable, so that each and every cycle of the recovered clock may have a slightly different absolute time duration. If all the waveforms in Figure 2 are overlaid with the same sample rate, this effectively freezes the clock recovery for the duration of the waveform segment rather than letting the received clock instances of the individual waveform vary independently as they theoretically should.

Although the averaging technique for determining a correlated waveform may work well in many cases, the averaging technique gives poor results when high-amplitude deterministic jitter is present, as mentioned above. High-amplitude deterministic jitter is very relevant in receiver testing, where a dominant sinusoidal modulation, periodic jitter (PJ), is intentionally introduced to quantify a receiver's ability to track such modulation properly.

Consider, for example, a repeating waveform with only 2 bits (i.e. "1 0") with fast rise and fall times, as shown in Figure 4. Suppose the time base for this repeating waveform was modulated with a sinusoidal phase modulation with a peak-to-peak amplitude of approximately $1/5^{th}$ of a bit interval. If the frequency of modulation is sufficiently low, many forms of clock recovery, which controls the trigger position used to overlay the waveform repeats that are averaged, would 'track' and therefore would remove the modulation.

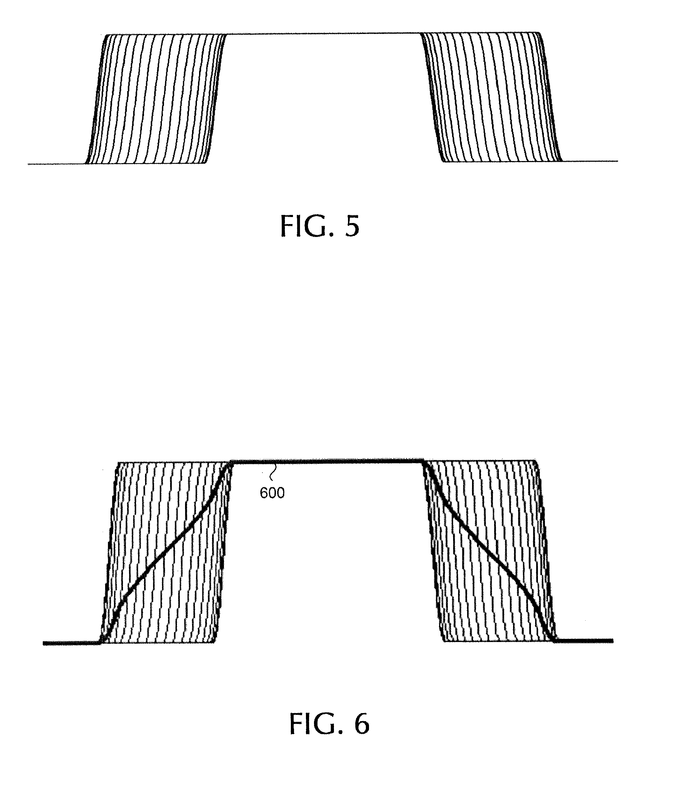

In that case, the correlated waveform and eye diagram would be unaffected to any large extent. However, if the modulation frequency is too high to be tracked by the clock recovery, the set of waveforms that would be averaged to obtain the correlated waveform might look like those shown in Figure 5. Since the modulation hasn't been tracked by the trigger circuit, its effects are clearly visible in the overlaid waveform segments.

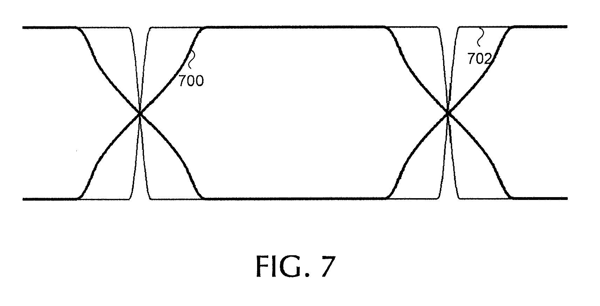

When all the segments of the waveform in Figure 5 at any given sample time relative to the recovered clock (corresponding to a vertical line across the segments) are averaged to create the correlated waveform, the result is as shown by waveform 600 in Figure 6. If the correlated waveform of Figure 6 is used to create a correlated eye diagram, the results will be something like that shown by the heavy lines 700 in Figure 7. For comparison, the preferred correlated eye diagram, obtained by superimposing horizontally-offset versions of the actual waveform, is shown by the lighter-weight lines 702 in Figure 7.

As can be seen in Figure 7, it is clear the eye opening has been substantially distorted using the averaged correlated waveform. Although Figure 7 only shows an eye resulting from the correlated waveform, the full eye diagram that includes the uncorrelated effects is based on this and will show similar effects. Any mask testing or other metrics which depend in any way on the correlated waveform will also be corrupted.

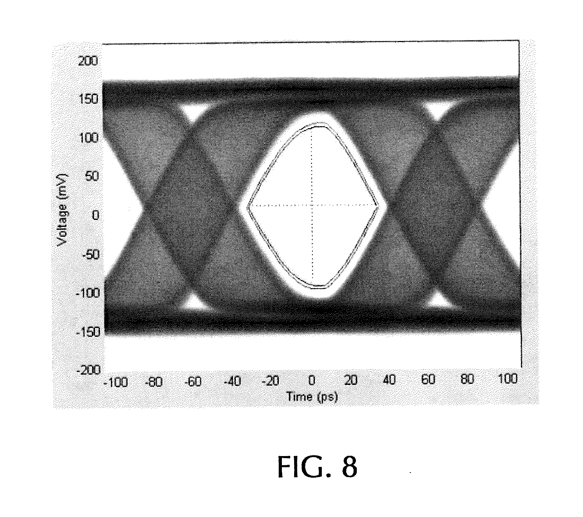

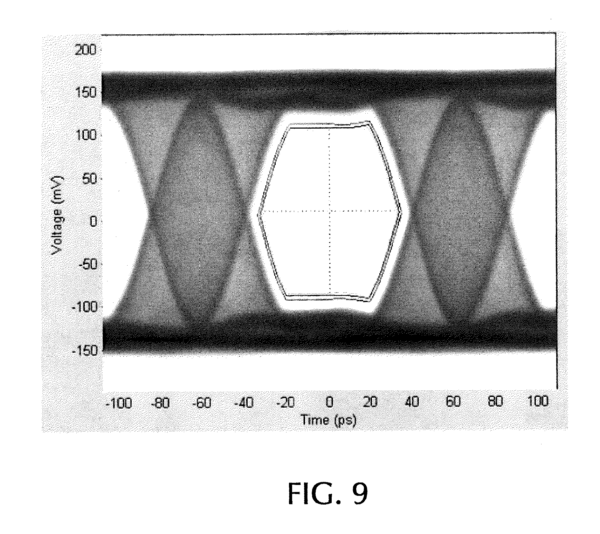

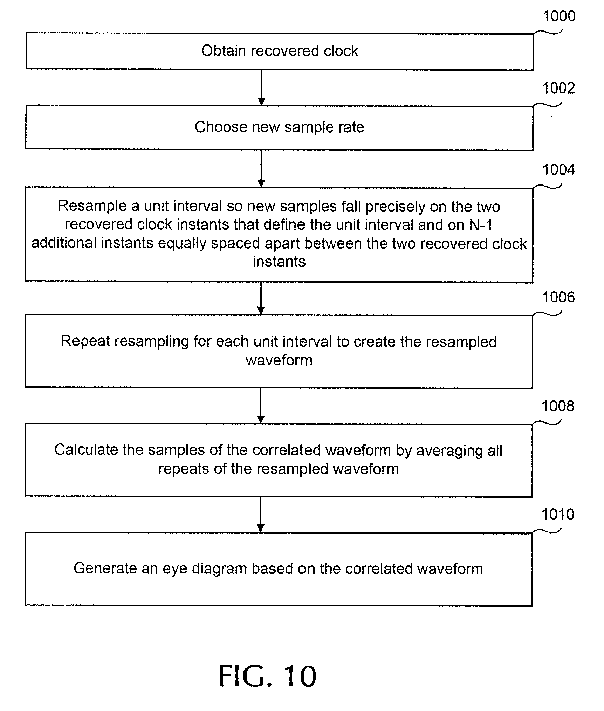

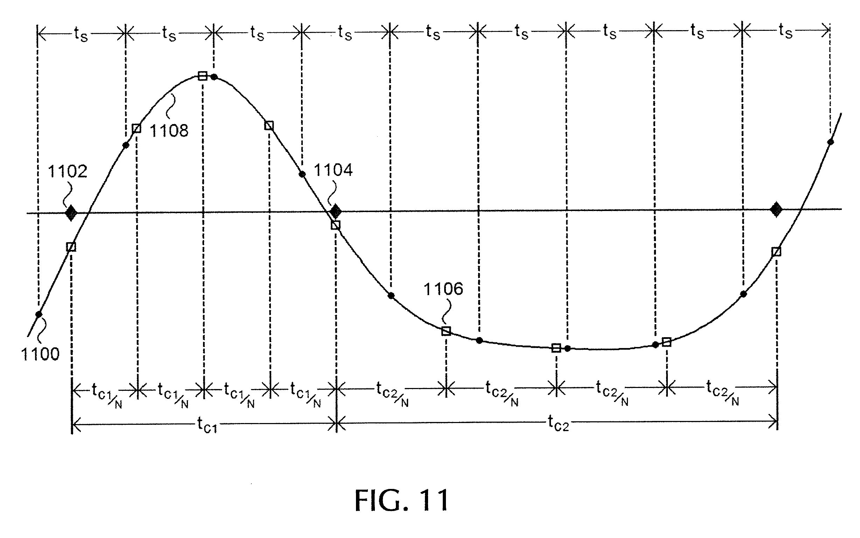

Figures 8 and 9 show two eye diagrams from the same real waveform, with the only difference being the treatment of the uncorrelated deterministic jitter when creating the eye diagram. Figure 8 shows the eye diagram with the averaged correlated waveform, while Figure 9 shows the eye diagram generated using the method of the disclosed technology, discussed in more detail below and shown in Figures 10 and 11. Practitioners in the art will appreciate that Figure 9 shows a much more accurate eye opening than Figure 8.

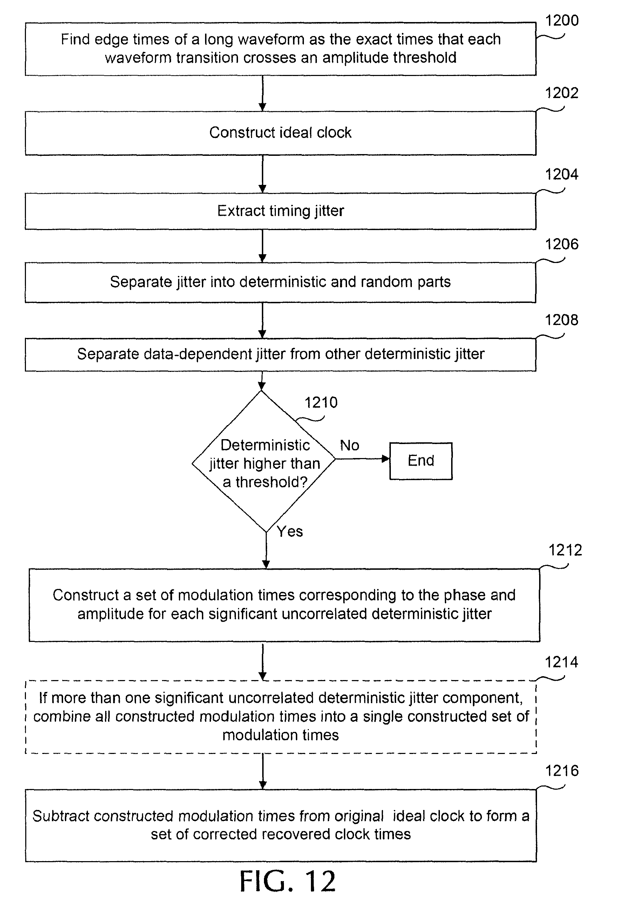

In operation 1000 in Figure 10, an ideal clock corresponding to a serial data waveform is obtained through a clock recovery process. Optionally, a version of the ideal clock which has been further corrected for significant uncorrelated deterministic jitter, as described in Figure 12 below, may be used. In the subsequent operation, either the conventional recovered clock or the corrected recovered lock is referred to as the recovered clock.

In operation 1002, for a given nominal clock rate, a new sample rate that is higher than the clock rate by an integer N multiplier is chosen, where N is greater than 1. In an exemplary implementation, N may be 10 to 16. In Figure 11, N = 4 for clarity of illustration.

Each pair of recovered clock instants defines a unit interval. In Figure 11, first recovered clock instant 1102 and second recovered clock instant 1104 define the first unit interval. In operation 1004, for each unit interval, the original waveform, consisting of a series of samples equally spaced apart in time at the oscilloscope's original sample rate, is resampled such that new samples fall precisely on the two recovered clock instants that define the unit interval, and on N-1 additional instants equally spaced apart between the recovered clock instants. In Figure 11, original acquired samples 1100 are spaced equally in time with original spacing $t_s$. The new samples 1106 divide each individual unit interval equally by N. The resampling is done using sin x/x, spline, or similar known techniques.

In step 1006, this process is repeated for each unit interval across the entire waveform, resulting in a new waveform that has precisely N samples per unit interval, regardless of whether the unit intervals, as defined by the clock recovery process, have equal durations. This is referred to as the resampled waveform. This waveform has an independent axis that is evenly spaced in unit intervals, rather than evenly spaced in time.

Given that the waveform was known to have a cyclically repeating pattern of K bits, the resampled waveform will nominally repeat with respect to its gross features every N*K samples. Define P = N*K to be the number of (post-resampling) waveform samples per pattern repeat. Then the number of samples in the correlated waveform will also be P, since the correlated waveform is exactly one repeat of the pattern. In operation 1008, each of the P samples of the correlated waveform is determined from the resampled waveform by taking the mean value of all the samples, one from each pattern-repeat, corresponding to the same offset in the pattern as the desired sample of the correlated waveform. If the (post-resampling) waveform samples are designated $R_i$, and if the resampled waveform has exactly L full repeats of the pattern, the correlated waveform samples $C_p$ are determined from:

$$C_p = \frac{1}{L}\sum_{i=1}^{L} R_{(i-1)*P+p} \qquad 1 \le p \le P$$

For example, if N =10 and K = 4 so that P = 40, and if L = 5, then

$$C_1 = \frac{1}{5}\left(R_1 + R_{41} + R_{81} + R_{121} + R_{161}\right)$$

$$C_2 = \frac{1}{5}\left(R_2 + R_{42} + R_{82} + R_{122} + R_{162}\right)$$

etc. for $C_1$ - $C_{40}$.

It is not necessary that the full waveform have an integral number of repeats L, and the samples from any partial repeat can either be included in the averaging operation for the affected samples of the correlated waveform or the partial repeat may be discarded.

In operation 1010, the eye diagram of Figure 9 is generated using the correlated waveform from operation 1008 by convolving the correlated waveform with the non-correlated effects.

Figure 12 shows a method for obtaining a corrected recovered clock that has been corrected for significant uncorrelated deterministic jitter, as discussed above with respect to Figure 10. In operation 1200, the edge times for a suitably long waveform, representing many repeats of a data pattern, are precisely found as the exact time that each waveform transition crosses a chosen amplitude threshold. The chosen amplitude threshold may be, for example, nominally near the midpoint of the waveform's vertical span. These times are found with greater resolution than the sample interval of the digital oscilloscope, using a suitable interpolation process.

In operation 1202, the ideal clock corresponding to the waveform is initially constructed as a chronologically ascending sequence of time instants which are nominally equally spaced although they typically have small variations. The various processes for doing this step, known as clock recovery, are known and include phase locked loops, delay locked loops, linear mean-squared best fit and other methods. The nominal spacing of the time instants is referred to as the unit interval.

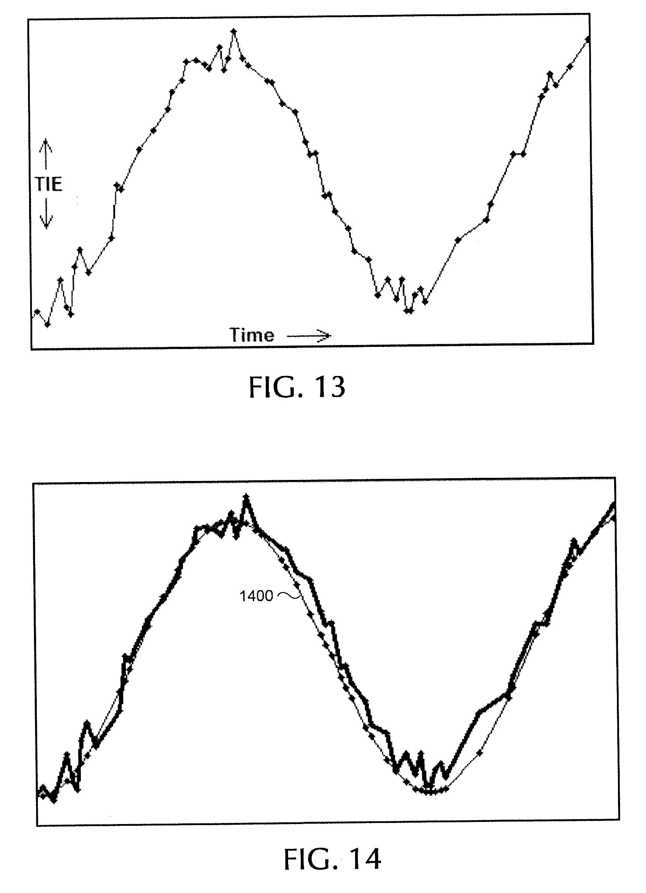

In operation 1204, the observed timing jitter is extracted by subtracting the edge times from the first step from the corresponding clock times from step 1202. The result of this subtraction is called Time Interval Error (TIE) or jitter. TIE may be plotted versus time to give a plot such as shown in Figure 13, which shows the TIE for a waveform with a single strong sinusoidal deterministic component plus some random jitter.

In operation 1206, the jitter is separated into deterministic and random parts. The most common method to do this is to perform a Fourier transform on the time record of jitter and to use the appearance of deterministic jitter as maxima in the amplitude spectrum to identify their frequency and phase. However, other approaches may also be used.

In operation 1208, the deterministic jitter due to pattern-correlated effects, data-dependent jitter (DDJ), is separated from deterministic jitter uncorrelated with the pattern repeat rate. This may be done, for example, by categorizing the pattern-related spectral components due to the frequencies at which they appear.

In operation 1210, the amplitude of the uncorrelated deterministic jitter components may be optionally compared to a threshold. If no component amplitudes are higher than a threshold, it may be that no further processing is required since the amount of eye diagram distortion would be minimal. If any component amplitudes are higher than a threshold, the process moves on to operation 1212.

In operation 1212, for each uncorrelated deterministic jitter component judged to be significant, a set of modulation times corresponding to the amplitude and phase of the significant component, as sampled at the recovered clock times, is constructed. For the TIE graph shown in Figure 13, the constructed set corresponding to the sinusoidal modulation look as shown by the lighter weight line 1400 in Figure 14.

In operation 1214, if there is more than one significant uncorrelated deterministic jitter component, the constructed modulation times from operation 1212 are combined into a single constructed set of modulation times.

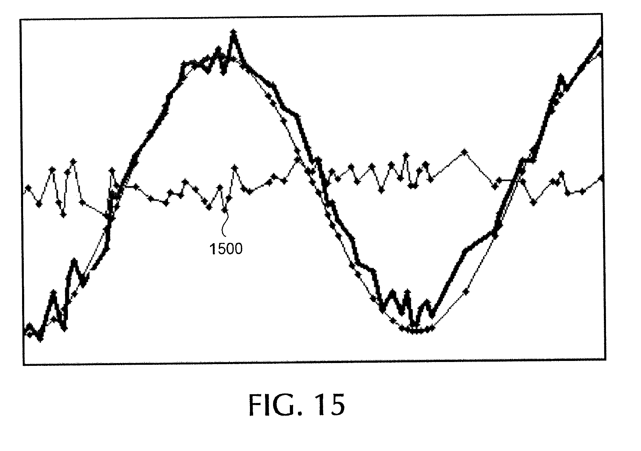

In operation 1216, the constructed modulation times representing all the significant components are subtracted from the original recovered clock times to form a set of corrected recovered clock times. For example, a new set of TIE times 1500 derived from the set of corrected times is overlaid in Figure 15.

In subsequent processing to obtain the correlated waveform, the corrected clock-recovery times are used in place of the original clock recovery times.

Some examples provide a method for determining a correlated waveform, comprising acquiring a generalized waveform record with a repeating pattern by an acquisition unit of a test and measurement instrument, determining a recovered clock signal for the generalized waveform record, selecting a new sample rate that is higher than the clock rate by a factor N, where N is an integer greater than 1, resampling the generalized waveform so that new samples fall precisely on two clocks instants of the recovered clock signal that define each unit interval, and on N-1 additional instants equally spaced between the two clock instants of each unit interval to create a resampled waveform, and taking mean values of all samples from the resampled waveform having the same offset into a pattern repeat in unit intervals, or fractions thereof, to form the correlated waveform.

In some examples the method further comprises generating an eye diagram based on the correlated waveform.

Some examples provide the method, further comprising wherein determining the recovered clock signal includes subtracting constructed modulation times from an initially recovered clock to form a corrected recovered clock signal.

Some examples provide the method, further comprising wherein the constructed modulation times are determined by constructing an initial recovered clock, extracting jitter from the generalized waveform, separating the jitter into deterministic and random portions separating the deterministic portion into data-dependent jitter and uncorrelated deterministic jitter, and determining the constructed modulation times corresponding to amplitude and phase of one or more significant components of the uncorrelated deterministic jitter.

Some examples provide the method, further comprising wherein P = N*K is the number of waveform samples per pattern repeat, where N is the number of repeats and K is a number of bits in the repeating pattern, and the correlated waveform samples Cp are determined from $C_p = \frac{1}{L}\sum_{i=1}^{L} R_{(i-1)*P+p}$ $1 \leq p \leq P$, where Ri is the waveform samples.

Some examples provide a test and measurement instrument, comprising acquisition means configured to receive a generalized waveform record with a repeating pattern, and a processing means configured to determine a recovered clock signal for the generalized waveform record, select a new sample rate that is higher than the clock rate by N time, where N is an integer greater than 1, resample the generalized waveform so that the new samples fall precisely on two clocks instants of the recovered clock signal that define each unit interval, and on N-1 additional instants equally spaced between the two clock instants of each unit interval to create a resampled waveform, form the correlated waveform by taking the mean values of all samples from the resampled waveform having the same offset into a pattern repeat in unit intervals or fractions thereof.

In some examples the processing means is a processor.

Some examples provide the test and measurement instrument, wherein the processing means is further configured to generate an eye diagram based on the correlated waveform.

Some examples provide the test and measurement instrument, wherein the recovered clock signal is determined by subtracting constructed modulation times from an initially recovered clock to form a corrected recovered clock signal.

Some examples provide the test and measurement instrument, wherein the processing means is further configured to determine the constructed modulation times by constructing an initial recovered clock, extracting jitter from the generalized waveform, separating the jitter into deterministic and random portions, separating the deterministic portion into data-dependent jitter and uncorrelated deterministic jitter, and determining the constructed modulation times corresponding to amplitude and phase of one or more significant components of the uncorrelated deterministic jitter.

Some examples provide the test and measurement instrument, wherein P = N*K is the number of waveform samples per pattern repeat, where N is the number of repeats and K is a number of bits in the repeating pattern, and the correlated waveform samples Cp are determined from $C_p = \frac{1}{L}\sum_{i=1}^{L} R_{(i-1)*P+p}$ $1 \leq p \leq P$, where Ri is the waveform samples.

Having described and illustrated the principles of the disclosed technology in a preferred embodiment thereof, it should be apparent that the disclosed technology can be modified in arrangement and detail without departing from such principles. We claim all modifications and variations coming within the scope of the following claims.

## Claims

1. A method for determining a correlated waveform, comprising:

acquiring a generalized waveform record with a repeating pattern by an acquisition unit of a test and measurement instrument;

determining a recovered clock signal for the generalized waveform record;

selecting a new sample rate that is higher than the clock rate by a factor N, where N is an integer greater than 1;

resampling the generalized waveform so that new samples fall precisely on two clocks instants of the recovered clock signal that define each unit interval, and on N-1 additional instants equally spaced between the two clock instants of each unit interval to create a resampled waveform;

taking mean values of all samples from the resampled waveform having the same offset into a pattern repeat in unit intervals, or fractions thereof, to form the correlated waveform.

2. The method of claim 1, further comprising generating an eye diagram based on the correlated waveform.

3. The method of any of claims 1 or 2, wherein determining the recovered clock signal includes subtracting constructed modulation times from an initially recovered clock to form a corrected recovered clock signal.

4. The method of claim 3, wherein the constructed modulation times are determined by:

constructing an initial recovered clock;

extracting jitter from the generalized waveform;

separating the jitter into deterministic and random portions;

separating the deterministic portion into data-dependent jitter and uncorrelated deterministic jitter; and

determining the constructed modulation times corresponding to amplitude and phase of one or more significant components of the uncorrelated deterministic jitter.

5. The method of any of claims 1 to 4, wherein P = N*K is the number of waveform samples per pattern repeat, where N is the number of repeats and K is a number of bits in the repeating pattern, and the correlated waveform samples $C_p$ are determined from:

$$C_p = \frac{1}{L}\sum_{i=1}^{L} R_{(i-1)*P+p} \qquad 1 \le p \le P,$$

where $R_i$ is the waveform samples.

6. A test and measurement instrument, comprising:

acquisition means configured to receive a generalized waveform record with a repeating pattern; and
a processing means configured to:

determine a recovered clock signal for the generalized waveform record;

select a new sample rate that is higher than the clock rate by N time, where N is an integer greater than 1;

resample the generalized waveform so that the new samples fall precisely on two clocks instants of the recovered clock signal that define each unit interval, and on N-1 additional instants equally spaced between the two clock instants of each unit interval to create a resampled waveform;

form the correlated waveform by taking the mean values of all samples from the resampled waveform having the same offset into a pattern repeat in unit intervals or fractions thereof

7. The test and measurement instrument of claim 6, wherein the processing means is further configured to generate an eye diagram based on the correlated waveform.

8. The test and measurement instrument of any of claims 6 or 7, wherein the recovered clock signal is determined by subtracting constructed modulation times from an initially recovered clock to form a corrected recovered clock signal.

9. The test and measurement instrument of claim 8, wherein the processing means is further configured to determine the constructed modulation times by:

constructing an initial recovered clock;

extracting jitter from the generalized waveform;

separating the jitter into deterministic and random portions;

separating the deterministic portion into data-dependent jitter and uncorrelated deterministic jitter; and

determining the constructed modulation times corresponding to amplitude and phase of one or more significant components of the uncorrelated deterministic jitter.

10. The test and measurement instrument of any of claims 6 to 9, wherein P = N*K is the number of waveform samples per pattern repeat, where N is the number of repeats and K is a number of bits in the repeating pattern, and the correlated waveform samples $C_p$ are determined from:

$$C_p = \frac{1}{L}\sum_{i=1}^{L} R_{(i-1)*P+p} \qquad 1 \leq p \leq P,$$

where $R_i$ is the waveform samples.

FIG. 1

FIG. 2

FIG. 3

FIG. 4

FIG. 5

FIG. 6

FIG. 7

FIG. 8

FIG. 9

1000
Obtain recovered clock

1002
Choose new sample rate

1004
Resample a unit interval so new samples fall precisely on the two recovered clock instants that define the unit interval and on N-1 additional instants equally spaced apart between the two recovered clock instants

1006
Repeat resampling for each unit interval to create the resampled waveform

1008
Calculate the samples of the correlated waveform by averaging all repeats of the resampled waveform

1010
Generate an eye diagram based on the correlated waveform

FIG. 10

FIG. 11

Find edge times of a long waveform as the exact times that each waveform transition crosses an amplitude threshold — 1200

Construct ideal clock — 1202

Extract timing jitter — 1204

Separate jitter into deterministic and random parts — 1206

Separate data-dependent jitter from other deterministic jitter — 1208

Deterministic jitter higher than a threshold? — 1210

No → End

Yes

Construct a set of modulation times corresponding to the phase and amplitude for each significant uncorrelated deterministic jitter — 1212

If more than one significant uncorrelated deterministic jitter component, combine all constructed modulation times into a single constructed set of modulation times — 1214

Subtract constructed modulation times from original ideal clock to form a set of corrected recovered clock times — 1216

FIG. 12

FIG. 13

FIG. 14

FIG. 15

**EUROPEAN SEARCH REPORT**

Europäisches
Patentamt
European
Patent Office
Office européen
des brevets

Application Number

EP 15 17 7715

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2005/271087 A1 (AMAGAI MITSUO [JP]) 8 December 2005 (2005-12-08) * paragraph [0090] - paragraph [0122] * | 1-10 | INV. G01R13/02 G01R13/34 G01R31/317 |
| A | US 2007/118315 A1 (PANIS MICHAEL [US] ET AL) 24 May 2007 (2007-05-24) * paragraph [0030] - paragraph [0051] * | 1-10 | |
| A | DONGWOO HONG ET AL: "An Efficient Random Jitter Measurement Technique Using Fast Comparator Sampling", VLSI TEST SYMPOSIUM, 2005. PROCEEDINGS. 23RD IEEE PALM SPRINGS, CA, USA 01-05 MAY 2005, PISCATAWAY, NJ, USA,IEEE, 1 May 2005 (2005-05-01), pages 123-130, XP010809165, DOI: 10.1109/VTS.2005.30 ISBN: 978-0-7695-2314-9 * Chapter 3 * | 1-10 | |
| A | US 2010/158177 A1 (DOBLAR DREW G [US] ET AL) 24 June 2010 (2010-06-24) * paragraph [0027] - paragraph [0042] * | 1-10 | TECHNICAL FIELDS SEARCHED (IPC) G01R |

The present search report has been drawn up for all claims

| Place of search | Date of completion of the search | Examiner |
|---|---|---|
| Munich | 17 December 2015 | Meggyesi, Zoltán |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 2 985 610 A1**

## ANNEX TO THE EUROPEAN SEARCH REPORT
## ON EUROPEAN PATENT APPLICATION NO.

EP 15 17 7715

17-12-2015

| Patent document cited in search report | | Publication date | Patent family member(s) | | Publication date |
|---|---|---|---|---|---|
| US 2005271087 | A1 | 08-12-2005 | EP | 1645884 A1 | 12-04-2006 |
| | | | JP | 4607765 B2 | 05-01-2011 |
| | | | US | 2005271087 A1 | 08-12-2005 |
| | | | WO | 2005005997 A1 | 20-01-2005 |
| US 2007118315 | A1 | 24-05-2007 | JP | 5577035 B2 | 20-08-2014 |
| | | | JP | 2009516176 A | 16-04-2009 |
| | | | TW | I398645 B | 11-06-2013 |
| | | | US | 2007118315 A1 | 24-05-2007 |
| | | | WO | 2007059411 A2 | 24-05-2007 |
| US 2010158177 | A1 | 24-06-2010 | NONE | | |